(19) **Europäisches Patentamt**
**European Patent Office**
**Office européen des brevets**

(11) **EP 2 240 676 B1**

(12) **FASCICULE DE BREVET EUROPEEN**

(45) Date de publication et mention
de la délivrance du brevet:
**30.11.2011 Bulletin 2011/48**

(21) Numéro de dépôt: **09708261.4**

(22) Date de dépôt: **23.01.2009**

(51) Int Cl.:
**F02D 41/22** *(2006.01)*

(86) Numéro de dépôt international:
**PCT/FR2009/050099**

(87) Numéro de publication internationale:
**WO 2009/098420 (13.08.2009 Gazette 2009/33)**

(54) **PROCEDE DE DETECTION DE MICROCOUPURES ELECTRIQUES ET DE GESTION DU FONCTIONNEMENT D'UN MOTEUR**

VERFAHREN ZUR ERKENNUNG VON STROMIMPULSEN UND ZUR VERWALTUNG DES BETRIEBS EINES MOTORS

METHOD FOR DETECTING ELECTRIC POWER BLIPS AND MANAGING THE OPERATION OF A MOTOR

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **05.02.2008 FR 0850721**

(43) Date de publication de la demande:
**20.10.2010 Bulletin 2010/42**

(73) Titulaire: **Renault s.a.s.**
**92100 Boulogne-Billancourt (FR)**

(72) Inventeur: **MOUNETOU, Christophe**
**F-92240 Malakoff (FR)**

(74) Mandataire: **Rougemont, Bernard et al**
**Renault s.a.s**
**Technocentre**
**Sce 00267 TCR GRA 2 36**
**1, Avenue du Golf**
**78288 Guyancourt (FR)**

(56) Documents cités:
**EP-A- 1 653 067     EP-A- 1 878 899**
**US-B1- 6 446 605**

• **SAMARA P A ET AL: "Detection of sensor abrupt faults in aircraft control systems" PROCEEDINGS OF THE 2003 IEEE INTERNATIONAL CONFERENCE ON CONTROL APPLICATIONS. CCA 2003. ISTANBUL, TURKEY, JUNE 23 - 25, 2003; [IEEE INTERNATIONAL CONFERENCE ON CONTROL APPLICATIONS], NEW YORK, NY : IEEE, US, vol. 1, 23 juin 2003 (2003-06-23), pages 1366-1371, XP010652043 ISBN: 978-0-7803-7729-5**

## Description

La présente invention se rapporte à un procédé de détection de microcoupures dans la transmission d'une information électrique représentative d'une grandeur détectée par un capteur, vers une unité de contrôle électronique associée à un moteur à combustion interne ou électrique par exemple, notamment pour un véhicule automobile.

Elle se rapporte également à un procédé de gestion du fonctionnement d'un moteur à combustion interne qui met en oeuvre le procédé précédent.

Le domaine technique auquel se rapporte la présente invention est celui du contrôle moteur. Le "contrôle moteur" est le système de gestion d'un moteur avec l'ensemble de ses capteurs, actionneurs et liaisons inter systèmes (LIS). L'ensemble des lois de contrôle de commande (stratégies logicielles) et des paramètres de caractérisation (calibrations) d'un moteur est contenu dans un calculateur appelé UCE (unité de contrôle électronique).

Un des paramètres utilisés par l'UCE est la température du moteur. Il permet à la fois de corriger de nombreux paramètres de stratégies pour assurer le bon fonctionnement du moteur et de respecter les normes d'émissions pour les moteurs à combustion, mais aussi d'assurer la protection du moteur contre une éventuelle surchauffe.

Dans la suite de la présente description, nous allons décrire le cas de la détection d'une panne concernant la température du moteur. Il s'agit d'une détection de panne par une stratégie de surveillance de l'information température de refroidissement moteur.

Toutefois, la présente invention peut s'appliquer à d'autres grandeurs telles que la température d'huile, la pression dans une chambre du moteur, etc.

Pour assurer une température de fonctionnement optimale pour le moteur et aussi pour minimiser les émissions de polluants dans le cas d'un moteur à combustion interne (MCI), une consigne de température est choisie pour le moteur et est régulée par un thermostat autonome et/ou piloté, ou par un système de vannage.

Un capteur de température du liquide de refroidissement est implanté sur le moteur et permet d'avoir une image de la température moteur par le biais de la mesure de la température du liquide de refroidissement. Cette mesure de la température est utilisée comme entrée pour les stratégies de l'UCE.

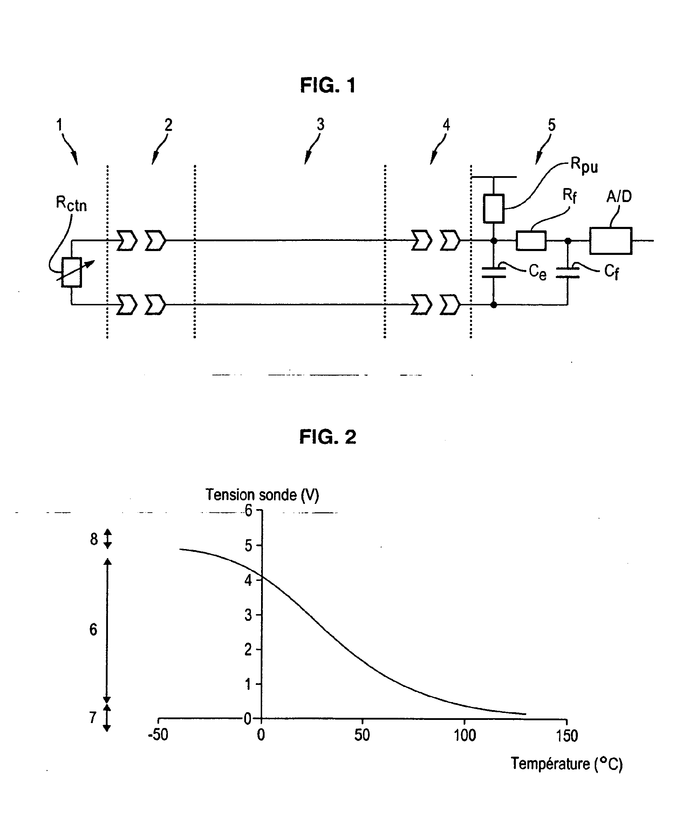

Ainsi que le montre la figure 1 annexée, ce capteur 1 est enfermé dans une capsule de protection assurant à la fois une bonne mesure de la température du liquide de refroidissement avec lequel elle est en contact. Une autre partie du capteur 1 est à l'air libre et présente une connectique 2 pour pouvoir transmettre une information électrique représentative de la température du liquide de refroidissement. Cette connectique est elle-même reliée à une partie du faisceau électrique 3 qui le relie à la connectique 4 du calculateur d'injection contenu dans l'UCE. C'est ce calculateur qui exploite cette information électrique via, entre autres, une linéarisation logicielle qui transforme ce signal électrique en une grandeur physique de température du liquide de refroidissement. Cette température est utilisée par l'UCE, qui la transmet aux autres calculateurs qui utilisent également cette température.

La référence 5 désigne l'étage d'entrée du calculateur et convertisseur analogique/digital.

Sur cette figure, les sigles utilisés ont la signification suivante:

- Rctn : résistance du capteur de température, de type CTN (c'est-à-dire à coefficient de température négatif),
- Rpu : résistance de "pull-up", c'est-à-dire résistance de tirage connectée à la borne "+" d'une alimentation stabilisée,
- Rf : résistance de filtrage,
- Ce : capacité d'entrée,
- Cf : capacité de filtrage,
- A/D : convertisseur analogique/digital.

La mesure de température est en premier lieu une information électrique et peut présenter des perturbations qui ne sont pas diagnostiquées électriquement, mais interprétées directement comme une température. La température mesurée peut donc être erronée, sans qu'elle soit reconnue comme telle par le calculateur d'injection.

Par conséquent, les corrections appliquées par le biais de la température de refroidissement peuvent être trop ou pas assez importantes et des mesures ont montré que la température apparente, c'est-à-dire celle donnée par la mesure du capteur, est souvent plus faible que la réalité.

Une température plus faible que la température réelle peut avoir les conséquences suivantes.

En premier lieu, une mauvaise estimation des pertes par frottement du moteur : une des informations principales pour l'estimation des pertes ramenées au moteur est la température du moteur et ces pertes peuvent représenter plusieurs dizaines de N.m. en absolu. Une surestimation des pertes peut donc être présente.

En deuxième lieu, la régulation du ralenti : une mauvaise estimation des pertes perturbe la boucle ouverte des compensations du régime du ralenti en fonction de la température et peut corriger le ralenti à une valeur surélevée.

Par ailleurs, pour des cas extrêmes relatifs aux moteurs diesels, la régénération du filtre à particules peut être avortée par l'automate de supervision de celui-ci. En effet, une température d'eau trop faible amènera à des sorties de régénération non justifiées et non maîtrisées (c'est-à-dire sans déclaration d'échec ou succès, sans actualisation de la masse de l'estimateur de particules).

Pour un moteur essence, une sur-correction de l'avance à l'allumage (correction correspondant à une estimation de température froide alors que le moteur est dans une zone de fonctionnement chaude) provoque un cliquetis qui peut être endommageant pour le moteur.

A la figure 2 est représentée une courbe de linéarisation de la tension, fonction de la température lue par le capteur. C'est cette température qui est lue par l'UCE. La tension est lue en entrée du convertisseur analogique/digital, et est traduite en une grandeur physique après linéarisation (température).

Trois zones de tensions sont définies au niveau de cette courbe, à savoir : une zone utile 6 et deux zones (zones CCmasse et CO/CC+) de diagnostic 7 et 8 auxquelles correspondent une détection électrique de panne.

La zone 8 est dite "CO/CC+" pour "circuit ouvert/court-circuit au plus de l'alimentation", tandis que la zone 7 est dite "CCmasse" pour "court-circuit à la masse".

Une tension trop proche du + 5 volts (circuit ouvert ou court-circuit au plus 5 volts d'alimentation) ou de la masse (court-circuit à la masse) permet de détecter que la tension s'éloigne de la zone utile et donc de déduire une défaillance électrique (débranchement ou court-circuit dans le câblage). La conséquence est qu'on ne sait plus mesurer la température.

Ce mode de détection a cependant des limites.

Ainsi, une température qui est perturbée ou déplacée mais qui reste dans la zone utile n'est pas détectée électriquement.

Il existe aussi des modèles de température d'eau permettant de faire une corrélation température mesurée/température estimée. Mais soit le modèle demande des informations qui ne sont pas à disposition dans un véhicule, soit le modèle est trop simpliste et ne permet pas de détecter correctement une panne lorsque le signal du capteur reste dans la zone utile.

Le document EP-A-1 878 899 décrit un procédé de détection d'anormalités d'un capteur par calculer la dérivée seconde de la valeur représentatif d'une grandeur détectée par un capteur.

On décrit par ailleurs dans le document EP-A-1 653 067 un procédé de détection du fonctionnement anormal d'un capteur de la température du liquide de refroidissement d'un moteur. On détecte un fonctionnement anormal lorsque, après démarrage du moteur, la température détectée est inférieure à celle détectée juste au moment du démarrage.

Une telle technique, de même que la précédente, ne permet pas la détection de microcoupures d'ordre électrique dans la transmission de l'information électrique provenant de la mesure du capteur.

Un objet de l'invention est donc de proposer un procédé qui permet la détection de telles microcoupures.

Un autre objet est de fournir un procédé de gestion du fonctionnement d'un moteur qui tient compte d'une telle détection.

Un premier aspect de l'invention est donc relatif à un procédé de détection de microcoupures électriques lors de la transmission d'un signal électrique représentatif d'une grandeur détectée par un capteur, vers une unité de contrôle électronique associée à un moteur.

Il est remarquable en ce qu'il comprend les étapes qui consistent à:

> a) mesurer ledit signal électrique dit "signal brut" ;
> b) procéder au filtrage dudit signal brut, de manière à obtenir un "signal filtré" ;
> c) calculer, pour un pas de temps constant, | signal brut - signal filtré |, c'est à dire la valeur absolue de la différence entre le signal brut et le signal filtré;
> d) comparer ladite valeur absolue à un seuil prédéterminé de variation maximale;
> e) quand ladite valeur absolue est supérieure audit seuil prédéterminé de variation maximale, déclarer un état de microcoupure ;
> f) dans le cas contraire, réitérer les étapes précédentes.

Grâce à ce procédé, les microcoupures électriques qui, jusqu'ici, n'étaient pas détectées, le sont et peuvent alors être considérées comme des anomalies.

Selon différentes caractéristiques avantageuses de ce procédé:

- à l'étape b), le filtrage consiste à comparer la vitesse d'évolution dudit signal à une vitesse maximale prédéfinie, et à affecter audit signal filtré, si la vitesse d'évolution du signal est plus rapide que la vitesse maximale (SFTE), une valeur prédéfinie qui correspond à ladite vitesse maximale prédéfinie ;
- à l'étape e), on incrémente un compteur de pannes élémentaires, et on déclare un état de microcoupure lorsque ce compteur atteint une valeur prédéterminée.

Un second aspect de l'invention concerne un procédé de gestion du fonctionnement d'un moteur, ce dernier comportant au moins un capteur de mesure d'une grandeur caractéristique dudit moteur, ainsi que des moyens électriques pour transmettre un signal électrique représentatif de ladite grandeur détectée par le capteur, vers une unité de contrôle électronique associée apte à interférer sur le fonctionnement dudit moteur.

Il est remarquable en ce qu'il intègre la mise en oeuvre du procédé tel que défini ci-dessus.

Selon différentes caractéristiques avantageuses de ce procédé:

- à l'étape e), on déclare un état de microcoupure et on affecte à ladite grandeur une valeur prédéterminée ou une évolution prédéterminée de valeurs, dite de mode dégradé ;
- ladite valeur prédéterminée ou évolution prédéterminée de valeurs est définie au moyen d'un modèle informatique associé à l'unité de contrôle électronique;

- l'information relative au passage en mode dégradé est conservée en mémoire dans l'unité de contrôle électronique, même après extinction du moteur ;
- ledit mode dégradé est conservé jusqu'à l'extinction du moteur ;
- ladite grandeur est la température du liquide de refroidissement du moteur ;
- ladite grandeur est la température de l'huile du moteur ;
- le moteur est un moteur à combustion et ladite grandeur est la pression régnant dans une chambre de combustion dudit moteur.

D'autres caractéristiques et avantages de la présente invention apparaîtront à la lecture de la description qui va suivre d'un mode de réalisation préférentiel. Cette description sera donnée en référence aux dessins annexés dans lesquels :

- la figure 1 est, comme déjà dit plus haut, un schéma de principe montrant les moyens de connexion d'un capteur au convertisseur d'une unité de contrôle électronique d'un moteur ;
- la figure 2 est une courbe de linéarisation de la tension, fonction de la température lue par ledit capteur ;
- la figure 3 est un schéma-bloc illustrant les principales étapes du procédé selon l'invention.

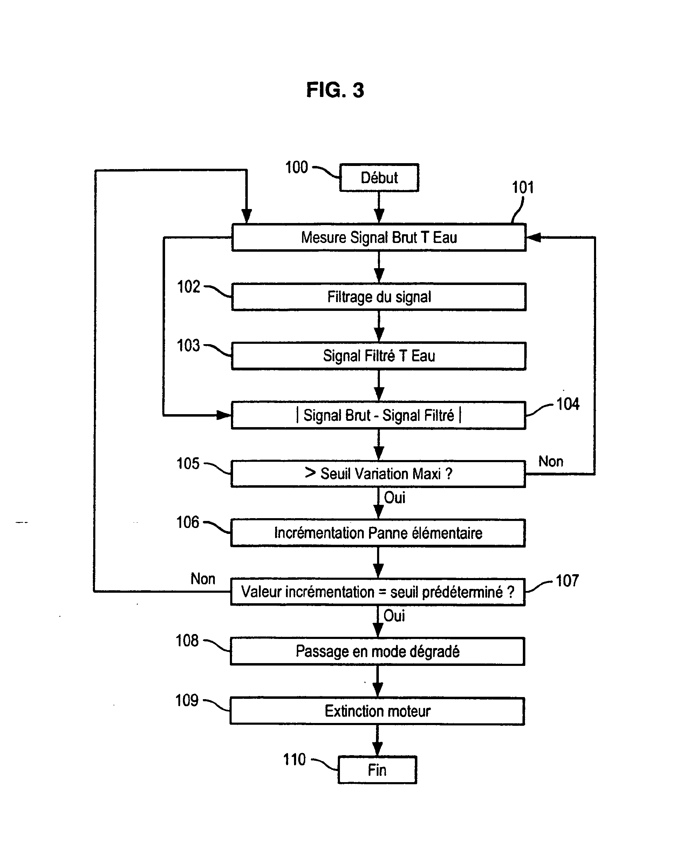

Après une étape préalable d'activation du procédé (bloc 100 de la figure 3) la première étape (étape a) du procédé de détection de microcoupures selon l'invention consiste à mesurer ledit signal électrique provenant du capteur (bloc 101).

Dans l'exemple représenté ici, il s'agit de mesurer la température de l'eau de refroidissement d'un moteur à combustion interne. Toutefois, il ne s'agit que d'un exemple, la grandeur pouvant par exemple être la température de l'huile moteur ou la pression régnant dans une chambre de combustion du moteur, ou encore une autre grandeur d'origine électrique. Plus généralement, il s'agit d'une grandeur spécifique au moteur et capable d'être mesurée par un capteur.

Le terme "capteur" doit être également compris comme signifiant également "sonde".

Ce signal est désigné 'Signal Brut T Eau" (en abrégé SBTE).

L'étape suivante consiste à filtrer le signal SBTE précédemment mesuré (bloc 102).

Ce filtrage est avantageusement un "slew-rate", qui consiste à comparer la vitesse d'évolution dudit signal brut SBTE à une vitesse maximale prédéfinie, et à affecter au signal filtré "Signal Filtré T Eau" (SFTE) une valeur prédéfinie qui correspond à ladite vitesse maximale prédéfinie.

La vitesse d'évolution peut être aussi bien une vitesse d'augmentation qu'une vitesse de diminution de la température. Et la vitesse maximale peut par exemple être de 1°C/s.

Ainsi, si la température "brute" varie trop rapidement, la température "filtrée" atteint une valeur maximum prédéfinie.

On procède alors au calcul de la valeur absolue de la différence entre les deux signaux SBTE et SFTE, soit | SBTE - SFTE | (bloc 104).

Cette valeur absolue est ensuite comparée à un seuil de variation maximum (SVM) dont la valeur est stockée dans l'unité de contrôle électronique (UCE) du moteur (bloc 105).

En d'autres termes, on vérifie si la relation suivante (I) est vérifiée:

$$| \ \text{SBTE - SFTE} \ | > \text{SVM (I)}$$

Si la relation (I) est vérifiée, on déclare alors un état de microcoupure.

Dans le cas contraire, on réitère les étapes précédentes du procédé. Même dans l'hypothèse où la relation est vérifiée, on peut continuer à faire ce test malgré tout, dont le résultat aura été mémorisé.

Ce procédé prend tout son sens quand il est mis en oeuvre dans le cadre d'un procédé de gestion du fonctionnement d'un moteur à combustion interne. Mais il peut être généralisé à tout type de moteur.

Ainsi, quand l'état de microcoupures est déclaré, on incrémente / ou on décrémente préférentiellement un compteur électronique de panne élémentaire (CPE) (bloc 106).

Quand ce compteur a atteint une valeur prédéterminée (VP), alors l'UCE bascule en "mode dégradé" (bloc 108).

Le "mode dégradé" consiste par exemple à basculer sur une température de remplacement calibrable ou pouvant évoluer, basée par exemple sur un modèle de température d'eau embarqué dans l'UCE.

Cette nouvelle température, même si elle est moins précise, garantit de ne pas provoquer de conséquences de la défaillance trop importante (dont les conséquences ont été évoquées au début de la description).

Sur confirmation de la panne, un message de diagnostic de panne sera mémorisé dans l'UCE et permettra ainsi d'aider à la réparation ultérieure du moteur.

De plus, pour ce type de panne, au lieu de ressortir du mode dégradé si la panne se résorbe (comme lors d'une détection de type CCmasse par exemple), on reste préférentiellement en mode dégradé jusqu'à la fin du cycle de roulage.

En effet, on considère, dans ce cas, que l'information issue du capteur n'est plus objective et que, même si elle retrouve une valeur plus stable, celle-ci n'est pas forcément une image correcte de la température réelle.

C'est alors seulement lors du prochain cycle de roulage que l'UCE réutilisera l'information issue du capteur, si aucune nouvelle panne n'est détectée.

Bien sûr, si la panne est détectée mais ne réapparaît plus, celle-ci reste mémorisée dans l'UCE pour un diagnostic ultérieur en garage, par exemple.

Après extinction du moteur (bloc 109), il est donc mis fin au procédé (bloc 110).

On considère dans l'exemple qui vient d'être décrit une vitesse maximum d'évolution du signal par rapport à la physique (bande passante de la mesure dans son contexte) dans un circuit de refroidissement pour un moteur à combustion. Si le signal varie trop rapidement, c'est qu'il est perturbé et ne reflète donc plus la mesure qu'il est censé représenter.

Ce principe peut bien entendu être considéré pour d'autres signaux que la température d'eau, par exemple la température d'huile moteur, un signal de pression, etc.

Ce principe peut aussi être considéré pour un moteur électrique.

De la même manière, il faut prendre en compte l'environnement du capteur. Ainsi, une température d'air sera plus dynamique qu'une température d'eau par exemple.

En plus de l'environnement, il faut garder à l'esprit l'architecture du circuit de refroidissement qui a une influence sur la dynamique du signal. Ainsi, pour l'exemple décrit ici, c'est le cas s'il y a une réserve chaude ou froide (radiateur) de liquide de refroidissement, ou dans l'hypothèse de différentes réponses en dynamique de certains actuateurs, tels un thermostat ou une vanne par exemple.

Il est fait état ici de détection de microcoupures, car c'est un mode de défaillance possible d'une connectique dans un véhicule pour diverses raisons (vieillissement, connectique abimée ou exposée à des vibrations (environnement moteur), humidité...).

Mais ce diagnostic est plus global et englobe plusieurs phénomènes. S'il s'agissait de microcoupures pures, le signal pourrait atteindre sa tension d'alimentation (ici de 5 volts ou température équivalente très froide comme lors d'un CO) à travers la constante de filtrage des composants de l'étage d'entrée du calculateur. Or, ce cas n'est pas présenté ici. Lors d'une microcoupure, si la connectique est oxydée (présence d'humidité + vibrations + tension électrique), alors la microcoupure peut être vue de l'UCE comme une nouvelle résistance rajoutée par rapport à la sonde de température et ainsi fausser le signal. C'est le cas lorsque le signal prend brutalement une valeur autour d'une nouvelle plage de température bruitée ou non.

Cette manière de détecter une panne reste un moyen simple (peu de calibrations et de calculs). Il permet d'éviter de recourir à un modèle calibré pour comparer la mesure à diagnostiquer à ce modèle qui peut rapidement devenir complexe, consommer beaucoup de mémoire et d'autres informations provenant du capteur.

**Revendications**

**1.** Procédé de détection de microcoupures électriques lors de la transmission d'un signal électrique représentatif d'une grandeur détectée par un capteur (1), vers une unité de contrôle électronique associée à un moteur, **caractérisé par le fait qu'**il comprend les étapes qui consistent à :

a) mesurer ledit signal électrique dit "signal brut" (SBTE) ;
b) procéder au filtrage dudit signal brut, de manière à obtenir un "signal filtré" (SFTE) ;
c) calculer, pour un pas de temps constant, signal brut - signal filtré |, c'est à dire la valeur absolue de la différence entre le signal brut et le signal filtré;
d) comparer ladite valeur absolue à un seuil prédéterminé de variation maximale (SVM) ;
e) quand ladite valeur absolue est supérieure audit seuil prédéterminé de variation maximale, déclarer un état de microcoupure ;
f) dans le cas contraire, réitérer les étapes précédentes.

**2.** Procédé selon la revendication 1, **caractérisé par le fait que**, à l'étape b), le filtrage consiste à comparer la vitesse d'évolution dudit signal à une vitesse maximale prédéfinie, et à affecter audit signal filtré, si la vitesse d'évolution du signal est plus rapide que la vitesse maximale (SFTE), une valeur prédéfinie qui correspond à ladite vitesse maximale prédéfinie.

**3.** Procédé selon la revendication 1 ou 2, **caractérisé par le fait qu'**à l'étape e), on incrémente / ou décrémente un compteur de pannes élémentaires (CPE), et que l'on déclare un état de microcoupure lorsque ce compteur (CPE) atteint une valeur prédéterminée.

**4.** Procédé de gestion du fonctionnement d'un moteur, ce dernier comportant au moins un capteur (1) de mesure d'une grandeur caractéristique dudit moteur, ainsi que des moyens électriques (2, 3, 4, 5) pour transmettre un signal électrique représentatif de ladite grandeur détectée par le capteur (1), vers une unité de contrôle électronique associée apte à interférer sur le fonctionnement dudit moteur, **caractérisé par le fait qu'**il intègre la mise en oeuvre du procédé selon l'une des revendications précédentes.

**5.** Procédé selon la revendication 4, **caractérisé par le fait qu'**à l'étape e), on déclare un état de microcoupure et on affecte à ladite grandeur une valeur prédéterminée ou une évolution prédéterminée de valeurs, dite de mode dégradé.

**6.** Procédé selon la revendication 5, **caractérisé par**

**le fait que** ladite valeur prédéterminée ou évolution prédéterminée de valeurs est définie au moyen d'un modèle informatique associé à l'unité de contrôle électronique.

7. Procédé selon l'une des revendications 5 ou 6, **caractérisé par le fait que** ledit mode dégradé est conservé jusqu'à l'extinction du moteur.

8. Procédé selon l'une des revendications 5 à 7, **caractérisé par le fait que** l'information relative au passage en mode dégradé est conservée en mémoire dans l'unité de contrôle électronique, même après extinction du moteur.

9. Procédé selon l'une des revendications précédentes, **caractérisé par le fait que** ladite grandeur est la température du liquide de refroidissement du moteur.

10. Procédé selon l'une des revendications 1 à 8, **caractérisé par le fait que** ladite grandeur est la température de l'huile du moteur.

11. Procédé selon l'une des revendications 1 à 8, **caractérisé en ce que** le moteur est un moteur à combustion et que ladite grandeur est la pression régnant dans une chambre de combustion dudit moteur.

**Claims**

1. Method for detecting electric dropouts during the transmission of an electric signal representative of a magnitude detected by a sensor (1) to an electronic control unit associated with an engine, **characterized in that** it comprises the steps which consist in:

   a) measuring said electric signal called "raw signal" (SBTE);
   b) filtering said raw signal so as to obtain a "filtered signal" (SFTE);
   c) calculating, for a constant time pitch | raw signal - filtered signal |, that is to say the absolute value of the difference between the raw signal and the filtered signal;
   d) comparing said absolute value with a predetermined threshold of maximum variation (SVM);
   e) when said absolute value is higher than said predetermined threshold of maximum variation, declaring a dropout state;
   f) otherwise, reiterating the preceding steps.

2. Method according to Claim 1, **characterized in that**, in step b), the filtering consists in comparing the speed of change of said signal with a predefined maximum speed, and in assigning to said filtered signal, if the speed of change of the signal is faster than the maximum speed (SFTE), a predefined value which corresponds to said predefined maximum speed.

3. Method according to Claim 1 or 2, **characterized in that**, in step e), an elementary fault counter (CPE) is incremented or decremented, and a dropout state is declared when this counter (CPE) reaches a predetermined value.

4. Method for managing the operation of an engine, the latter comprising at least one sensor (1) for measuring a characteristic magnitude of said engine, and electric means (2, 3, 4, 5) for transmitting an electric signal representative of said magnitude detected by the sensor (1), to an associated electronic control unit capable of interfering in the operation of said engine, **characterized in that** it incorporates the use of the method according to one of the preceding claims.

5. Method according to Claim 4, **characterized in that**, in step e), a dropout state is declared and a predetermined value or a predetermined change of values, called degraded mode, is assigned to said magnitude.

6. Method according to Claim 5, **characterized in that** said predetermined value or predetermined change of values is defined by means of a computer model associated with the electronic control unit.

7. Method according to one of Claims 5 or 6, **characterized in that** said degraded mode is maintained until the engine is switched off.

8. Method according to one of Claims 5 to 7, **characterized in that** the information relating to the transition to degraded mode is retained in memory in the electronic control unit, even after the engine is switched off.

9. Method according to one of the preceding claims, **characterized in that** said magnitude is the temperature of the liquid for cooling the engine.

10. Method according to one of Claims 1 to 8, **characterized in that** said magnitude is the temperature of the oil of the engine.

11. Method according to one of Claims 1 to 8, **characterized in that** the engine is a combustion engine and that said magnitude is the pressure prevailing in a combustion chamber of said engine.

## Patentansprüche

1. Verfahren zum Detektieren von elektrischen Mikrounterbrechungen bei der Übertragung eines elektrischen Signals, das eine von einem Sensor (1) detektierte Größe repräsentiert, zu einer einem Motor zugeordneten elektronischen Steuereinheit, **dadurch gekennzeichnet, dass** es die Schritte umfasst, die darin bestehen:

   a) das elektrische Signal, das "rohes Signal" (SBTE) genannt wird, zu messen;
   b) eine Filterung des rohen Signals vorzunehmen, um ein "gefiltertes Signal" (SFTE) zu erhalten;
   c) für einen konstanten Zeitschritt | rohes Signal - gefiltertes Signal |, d. h. den Absolutwert der Differenz zwischen dem rohen Signal und dem gefilterten Signal, zu berechnen;
   d) den Absolutwert mit einem vorgegebenen Schwellenwert der maximalen Schwankung (SVM) zu vergleichen;
   e) dann, wenn der Absolutwert größer ist als der vorgegebene Schwellenwert der maximalen Schwankung, Melden eines Mikrounterbrechungszustands;
   f) andernfalls Wiederholen der vorhergehenden Schritte.

2. Verfahren nach Anspruch 1, **dadurch gekennzeichnet, dass** im Schritt b) die Filterung darin besteht, die Geschwindigkeit der Entwicklung des Signals mit einer im Voraus definierten maximalen Geschwindigkeit zu vergleichen und dem gefilterten Signal dann, wenn die Entwicklungsgeschwindigkeit des Signals höher ist als die maximale Geschwindigkeit (SFTE), einen im Voraus definierten Wert zuzuweisen, der der im Voraus definierten maximalen Geschwindigkeit entspricht.

3. Verfahren nach Anspruch 1 oder 2, **dadurch gekennzeichnet, dass** im Schritt e) ein Elementarstörungs-Zähler (CPE) inkrementiert/dekrementiert wird und dass ein Mikrounterbrechungszustand gemeldet wird, wenn dieser Zähler (CPE) einen vorgegebenen Wert erreicht.

4. Verfahren zum Steuern des Betriebs eines Motors, wobei dieser Letztere wenigstens einen Sensor (1) zum Messen einer charakteristischen Größe des Motors sowie elektrische Mittel (2, 3, 4, 5) zum Übertragen eines elektrischen Signals, das die von dem Sensor (1) detektierte Größe repräsentiert, zu einer zugeordneten elektronischen Steuereinheit, die auf den Betrieb des Motors einwirken kann, umfasst, **dadurch gekennzeichnet, dass** es die Ausführung des Verfahrens nach einem der vorhergehenden Schritte umfasst.

5. Verfahren nach Anspruch 4, **dadurch gekennzeichnet, dass** im Schritt e) ein Mikrounterbrechungszustand gemeldet wird und dieser Größe ein vorgegebener Wert oder eine vorgegebene Entwicklung von Werten, die reduzierte Betriebsart genannt wird, zugewiesen wird.

6. Verfahren nach Anspruch 5, **dadurch gekennzeichnet, dass** der vorgegebene Wert oder die vorgegebene Entwicklung von Werten mittels eines informationstechnischen Modells, das der elektronischen Steuereinheit zugeordnet ist, definiert ist.

7. Verfahren nach einem der Ansprüche 5 oder 6, **dadurch gekennzeichnet, dass** die reduzierte Betriebsart bis zum Ausschalten des Motors beibehalten wird.

8. Verfahren nach einem der Ansprüche 5 bis 7, **dadurch gekennzeichnet, dass** die Informationen bezüglich des Übergangs in die reduzierte Betriebsart im Speicher der elektronischen Steuereinheit selbst nach dem Ausschalten des Motors gehalten werden.

9. Verfahren nach einem der vorhergehenden Ansprüche, **dadurch gekennzeichnet, dass** die Größe die Temperatur der Kühlflüssigkeit des Motors ist.

10. Verfahren nach einem der Ansprüche 1 bis 8, **dadurch gekennzeichnet, dass** die Größe die Temperatur des Öls des Motors ist.

11. Verfahren nach einem der Ansprüche 1 bis 8, **dadurch gekennzeichnet, dass** der Motor eine Brennkraftmaschine ist und dass die Größe der Druck ist, der in einer Brennkammer der Maschine herrscht.

**FIG. 1**

**FIG. 2**

## FIG. 3

100 — Début

101 — Mesure Signal Brut T Eau

102 — Filtrage du signal

103 — Signal Filtré T Eau

| Signal Brut - Signal Filtré | — 104

105 — > Seuil Variation Maxi ?          Non

Oui

106 — Incrémentation Panne élémentaire

Non    Valeur incrémentation = seuil prédéterminé ? — 107

Oui

108 — Passage en mode dégradé

109 — Extinction moteur

110 — Fin

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1878899 A
- EP 1653067 A